# EUROPEAN PATENT APPLICATION

(11) **EP 0 797 378 A2**
(43) Date of publication of application: **24.09.1997**
(21) Application number: 96306670.9
(22) Date of filing: 13.09.1996
(51) Int. Cl.: H05K 1/03, H05K 3/46, B32B 15/08, B32B 27/20

(54) **Copper-clad laminate, multilayer copper-clad laminate and process for producing the same**

(30) Priority: 21.03.1996 JP 63988/96; 21.03.1996 JP 63989/96
(71) Applicant: Hitachi Chemical Co., Ltd., Shinjuku-ku, Tokyo 160 (JP)
(72) Inventor: Okano, Norio, Tsukuba-shi (JP); Kobayashi, Kazuhito, Yuki-shi (JP); Nakaso, Akishi, Oyama-shi (JP)
(74) Representative: Marshall, Monica Anne

(57) **Abstract**

A copper-clad laminate comprising an electrically insulating layer comprising a thermosetting resin and electrically insulating whiskers, and a copper foil formed on at least one side of the insulating layer, the insulating layer and copper foil being integrated by thermal press molding, and a multilayer copper-clad laminate having an interlayer circuit therein, which laminate comprises an interlayer circuit plate, a copper foil for an outer circuit, and an electrically insulating layer interposed therebetween, the circuit plate, copper foil and insulating layer being integrated by thermal press molding, and the insulating layer comprising electrically insulating whiskers dispersed in a thermosetting resin, are effective for producing multilayer printed circuit boards with a very reduced thickness and high wiring density.

## Description

### BACKGROUND OF THE INVENTION

The present invention relates to a copper-clad laminate for multilayer printed circuit boards that can adapt itself to the elevating trend toward reduction of thickness and increased wiring density, a multilayer copper-clad laminate having interlayer circuit therein, and processes for producing laminates.

The copper-clad laminates used for the multilayer printed circuit boards have been produced generally by following the steps of impregnating an epoxy resin in glass cloth, heating and drying the impregnated cloth to remove the solvent while turning the resin into a half-cured state to form a prepreg, laminating a copper foil on at least one side of said prepreg, and subjecting them to thermal press molding. The copper-clad laminates produced in the manner described above have their insulating layers composed of a glass cloth-reinforced epoxy resin.

As means for producing the multilayer printed circuit boards, there is generally employed the technique of forming circuit on a multilayer copper-clad laminate having interlayer circuit incorporated therein. In the multilayer copper-clad laminate having interlayer circuit therein, circuit is already formed on each interlayer and a copper foil is laminated over the outer layer with an insulating layer interposed therebetween. Such multilayer copper-clad laminate having interlayer circuit therein is produced by laminating a prepreg on both sides of a printed circuit board or multilayer printed circuit board having circuit formed thereon, laminating a copper foil on the outer side thereof, and subjecting them to thermal press molding. The prepregs used here are generally the glass cloth prepregs obtained by impregnating a resin in glass cloth and drying the impregnated cloth with the resin kept in a half-cured state. Recently, however, there have been proposed an adhesive film comprising a half-cured-state thermosetting resin having film forming properties (JP-A-6-200216 and JP-A-6-242465), which is a prepreg using no glass cloth, and an adhesive film having a copper foil produced by forming said adhesive film, instead of prepreg, on one side of a copper foil (JP-A-6-196862).

Thus, the conventional multilayer copper-clad laminates having interlayer circuit therein are of a structure in which an electrically insulating layer composed of a resin and glass cloth or composed of a resin alone is sandwiched between the interlayer circuit and the copper foil of the outer layer.

With an elevating trend toward smaller size and weight, higher performance and lower cost of electronic devices in recent years, request is being intensified for smaller thickness, higher wiring density, higher productivity, higher reliability, higher operating speed and lower production cost of the printed circuit boards and the multilayer copper-clad laminates having interlayer circuits therein.

For realizing reduction of thickness of the printed circuit boards, it is essential to reduce thickness of the copper-clad laminates or the insulating layers between laminations in the circuit boards.

For attaining higher density of circuit, fine wiring is essential, and this requires high surface smoothness and dimensional stability of the board. Further, fine through-holes and interstitial via holes are needed, which calls for excellent drilling workability of the board. Also, high laser drilling workability is required for forming holes of microscopical diameters such as about 100 µm or less.

Elevation of productivity requires good wire bonding workability for reducing the parts packaging time as well as high rigidity of the base material for allowing enlargement of work size.

For attaining high reliability, it is necessary to reduce the coefficient of thermal expansion of the substrate for the improvement of connecting reliability with the packaged parts, and to improve plating adhesion and migration resistance of the substrate. These requirements can hardly be met by the conventional copper-clad laminates and multilayer copper-clad laminates having interlayer circuits therein.

In the glass cloth generally used in the copper-clad laminates and multilayer copper-clad laminates having interlayer circuit, the spaces between the yarns (glass fiber strands) are enlarged in accordance with a decrease of the thickness of the cloth. Therefore, the smaller the cloth thickness, the higher is the probability of causing such undesirable phenomena as improper curving of the yarns and non-right-angled crossing of warp and weft which should normally cross each other at right angles. These phenomena are responsible for abnormal dimensional changes or warps that may take place after thermal press molding. Further, since the inter-yarn spaces are enlarged as the glass cloth is made thinner, the volume fraction of the fibers in the prepreg or the insulating layer between laminations is lowered, resulting in a reduced regidity of the insulating layer. This gives rise to a problem of increased deflection in the parts packaging operation after the outer layer circuit working has been completed.

The smallest thickness of glass cloth in practical use at present is 30 µm, and the thickness of the prepreg using such glass cloth is about 30-40 µm. If the resin content is decreased for further reducing the thickness of the prepreg or the insulating layer between laminations, there arise troubles such as formation of voids, and further lessening of thickness of the glass cloth leads to reduced strength of the glass cloth itself, making the cloth liable to break in the step of resin impregnation in the cloth.

The copper-clad laminates or the multilayer copper-clad laminates having interlayer circuit therein manufactured by using such glass-cloth prepregs have problems in that there tends to take place lost of core center of a drill, which may result in breaking the drill, due to maldistribution of glass cloth in the microsized drilling operation, and that when drilling is made by using laser beams, straightness of laser beams may be damaged due to refraction or reflection of the beams caused by the glass fibers.

On the other hand, the multilayer copper-clad laminates having interlayer circuit therein comprising an adhesive film which is a prepreg with no glass cloth or using an adhesive film having a copper foil for the insulating layer between the inner and outer layers can be more reduced in thickness and are also excellent in microsize drilling workability, laser perforating workability and surface smoothness. These multilayer copper-clad laminates having interlayer circuits therein, however, are very low in rigidity because of absence of glass cloth reinforcement in the outer insulating layer. This low rigidity is especially remarkable under high temperatures and blamed for the warping tendency and poor wire bonding workability in the parts mounting operations. Absence of glass cloth in the outer insulating layer also invites problems in that because of the large coefficient of thermal expansion, the difference in thermal expansion between the laminate and the mounted parts is enlarged, resulting in reduced connecting reliability with the mounted parts, and that cracking or rupture tends to take place at the soldered joints due to reiteration of thermal expansion and shrinkage caused by heating and cooling.

### SUMMARY OF THE INVENTION

The present invention has been realized as a result of the studies for overcoming said prior art problems, and it has for its object offering of a copper-clad laminate and a multilayer copper-clad laminate having interlayer circuit therein which enable reduction of thickness of the multilayer printed circuit boards and can also realize high wiring density, high productivity, high reliability and low production cost, and processes for producing such laminates.

In accordance with the present invention, there are provided a copper-clad laminate comprising an electrically insulating layer composed of a thermosetting resin and electrically insulating whiskers, and a copper foil formed on at least one side of the insulating layer, said insulating layer and copper foil being integrated by thermal press molding, and a process for producing such a laminate.

The present invention also provides a multilayer copper-clad laminate having interlayer circuits therein comprising an interlayer circuit plate and a copper foil for an outer circuit with an electrically insulating layer interposed therebetween, said circuit plate and copper foil being integrated by thermal press molding, the insulating layer containing electrically insulating whiskers dispersed in a thermosetting resin, and a process for producing such a laminate.

### DESCRIPTION OF THE PREFERRED EMBODIMENTS

The copper-clad laminate according to the present invention is characterized in that it comprises an electrically insulating layer containing electrically insulating whiskers uniformly dispersed in a thermosetting resin, and a copper foil formed on at least one side of the insulating layer, said insulating layer and copper foil being integrated by thermal press molding.

The copper-clad laminate according to the present invention can be produced by a process which comprises uniformly dispersing electrically insulating whiskers in a thermosetting resin by means of stirring, coating the dispersion on the roughened side of a copper foil of which at least one side has been roughened, heating and drying the coating to remove the solvent while making the resin a half-cured or semi-cured state (i.e. in a B stage condition), laminating a release film on the non-clad side (prepreg side) of the obtained copper-clad prepreg, subjecting them to thermal press molding and then separating said film.

A double-sided copper-clad laminate can be obtained by preparing two sheets of said copper-clad prepreg, laminating them so that the prepreg sides of the respective sheets would face each other, and subjecting them to thermal press molding.

It is also possible to produce a double-sided copper-clad laminate by preparing a copper foil at least one side of which has been roughened, laminating this copper foil on said copper-clad prepreg so that the roughened side of said copper foil would face the prepreg side of said copper-clad prepreg, and subjecting them to thermal press molding. As the electrically insulating whiskers, there can be used electrically insulating ceramic whiskers preferably having a modulus of elasticity of 200 GPa or more. When the modulus of elasticity is less than 200 GPa, there is a tendency to fail to give a sufficient rigidity when a multilayer printed circuit board is made.

As to the kind of whiskers, there can be used at least one member selected from the group consisting of aluminum borate, wollastonite, potassium titanate, basic magnesium sulfate, silicon nitride, and α-alumina. Among them, since aluminum borate whiskers and potassium titanate whiskers have a Mohs hardness similar to that of E glass generally used in prepreg base material, these whiskers have drill processability similar to that of conventional prepregs. Further, aluminum borate whiskers have a modulus of elasticity of about 400 GPa, which value is by far higher than that of glass, and are relatively low in price. In addition, the aluminum borate whiskers are easily mixed with a resin varnish.

The prepreg containing the aluminum borate whiskers can give a printed circuit board having higher rigidity than obtained by using a prior art prepreg containing glass cloth at room temperature and under high temperatures, as well as having excellent connecting property by wire bonding and excellent dimensional stability. Thus, in the present invention, the use of the aluminum borate whiskers is most suitable.

The average diameter of electrically insulating whiskers is preferably 0.3 to 3 µm. When the average diameter is less than 0.3 µm, there is a tendency to make the mixing with a resin varnish difficult and to lower coating workability. On the other hand, when the average diameter is larger than 3 µm, there is a tendency to give a bad influence on surface smoothness and to lose uniform dispersion of the whiskers from microscopic point of view. In order to obtain smoother coating, it is preferable to make the average diameter fall in the range of 0.5 µm to 2 µm.

The average length of the whiskers is preferably 10 times or more of the average diameter. When the average length is less than 10 times of the average diameter, there is a tendency to lower reinforcing effect as fibers and to make two-dimensional orientation of whiskers in the resin layer difficult as mentioned below, resulting in failing to obtain sufficient rigidity as a printed circuit board. The average length of whiskers is more preferably about 20 times or more as long as the average diameter. When the whiskers are too long, uniform dispersion in a resin varnish becomes difficult, resulting in lowering coating workability. Further, when a whisker contacts with one conductor circuit, the probability of the whisker that contacts with another conductor circuit becomes high, resulting in causing migration of copper ions which have a tendency to move along fibers, and bringing about short-circuit between circuits. Therefore, the average length of 100 µm or less is preferable, and 50 µm or less is more preferable.

It is possible to use whiskers surface-treated with a coupling agent in order to further enhance rigidity and heat resistance of printed circuit boards. The whiskers surface-treated with a coupling agent can also improve wettability with the resin, binding properties, rigidity and heat resistance.

As the coupling agent, there can be used conventional coupling agents such as silicone series, titanium series, aluminum series, zirconium series, zirco-aluminum series, chrome series, boron series, phosphorus series and amino acid series.

As the thermosetting resin, there can be used thermosetting resins conventionally used for adhesive films or copper-clad adhesive films.

The term "thermosetting resin" used in the present invention includes not only a thermosetting resin per se, but also a curing agent, a curing accelerator, and if necessary, a coupling agent, a filler, a diluent and conventional additives.

As the kind of thermosetting resins, there can be used epoxy resins, bismaleimide-triazine resins, polyimide resins, phenol resins, melamine resins, silicone resins, unsaturated plyester resins, cyanic acid ester resins, isocyanate resins, polyamide resins, and various modified resins thereof. Among them, the use of bismaleimide-triazine resins, epoxy resins and polyimide reins are particularly preferable taking properties of printed circuit boards into consideration.

As the epoxy resins, there can be used bisphenol A epoxy resins, bisphenol F epoxy resins, bisphenol S epoxy resins, phenol novolak epoxy resins, cresol novolak epoxy resins, bisphenol A novolak epoxy resins, salicylaldehyde novolak epoxy resins, bisphenol F novolak resins, alicyclic epoxy resins, glycidyl ester epoxy resins, glycidylamine epoxy resins, hydantoin epoxy resins, isocyanurate epoxy resins, aliphatic cyclic epoxy resins, halides thereof, hydrides thereof, and mixtures thereof. Among them, bisphenol A novolak epoxy resins, and salicylaldehyde novolak epoxy resins are more preferably due to excellent heat resistance.

As the curing agent for such resins, there can be used conventional ones. In the case of epoxy resins, there can be used dicyandiamide, bisphenol A, bisphenol F, polyvinyl phenol, phenol novolak resin, bisphenol A novolak resin, halides or hydrides of these phenol resins.

The curing agent can be used in an amount of conventionally used one, preferably 2 to 100 parts by weight per 100 parts by weight of the resin.

In the case of dicyandiamide, it is preferable to use in an amount of 2 to 5 parts by weight per 100 parts by weight of the resin. In the case of other curing agent, it is preferable to use in an amount of 30 to 80 parts by weight per 100 parts by weight of the resin.

As the curing accelerator, there can be used conventional imidazoles, organic phosphorus compounds, tertiary amines, quaternary ammonium salts, etc., when the resin is an epoxy resin.

The curing accelerator can be used in an amount of preferably 0.01 to 20 parts by weight, more preferably 0.1 to 1.0 part by weight, per 100 parts by weight of the resin.

The thermosetting resin can be used as a resin varnish by diluting with an organic solvent. As the solvent, there can be used acetone, methyl ethyl ketone, toluene, xylene, methyl isobutyl ketone, ethyl acetate, ethylene glycol monomethyl ether, methanol, ethanol, N,N-dimethylformamide, N,N-dimethylacetamide, etc.

Further, it is also possible to use reactive diluents such as phenyl glycidyl ether, glycidyl methacrylate, dibutyl glycidyl ether, styrene oxide, methyl glycidyl ether, ethyl glycidyl ether, etc.

The solvent as the diluent can be used in an amount of 1 to 200 parts by weight, more preferably 30 to 100 parts by weight, per 100 parts by weight of the resin.

In the present invention, the resin can include conventional one or more coupling agents, fillers, and other conventional additives, if necessary, in addition to the curing agent, curing accelerator and solvent mentioned above.

The proportion of whiskers in the prepreg is preferably 5 to 50% by volume. When the proportion of whisker in the prepreg is less than 5% by volume, handling of the prepreg becomes worse, for example, the resin is ground finely at the time of cutting to easily fly off, and it is impossible to obtain sufficient rigidity. Further, curl of the prepreg attaching a carrier film becomes larger after drying to make the handling worse. On the other hand, when the proportion of whiskers is more than 50% by volume, hole filling properties in interlayer circuits or resin filling properties into circuits at the time of thermal press molding are damaged, resulting in easily causing voids and blurs (or thin spots) in the whisker dispersed resin layer after thermal press molding to damage properties of the resulting printed circuit board.

In order to attain excellent hole filling properties in interlayer circuits and resin filling properties into circuits, as well as equal or higher rigidity, dimensional stability and wire bonding properties of the produced printed circuit board compared with the printed circuit board using a prior art prepreg containing glass cloth, it is more preferable to use the whiskers in a proportion of 20 to 50% by volume in the prepreg.

As the copper foil on which a resin varnish containing the whiskers is to be coated, there can be used electrolytic copper foils, rolled copper foils, ultra-thin copper foils attached to carrier films, conventionally used for printed circuit boards and having a roughened surface at least one side of copper foil.

When a thermosetting resin layer containing the whiskers is formed on a smooth surface of copper foil, it is impossible to secure sufficient adhesion between the thermosetting resin layer containing the whiskers and the copper foil in the prepreg state or multilayer printed circuit board state. Thus, by forming the thermosetting resin layer containing the whiskers on the roughened surface of a copper foil, it is possible to secure sufficient adhesion between the thermosetting resin layer containing the whiskers and the copper foil in the prepreg state or multilayer printed circuit board state.

The varnish containing the whiskers can be applied to the carrier film by using a blade coater, a rod coater, a knife coater, a squeeze coater, a reverse roll coater, a transfer roll coater, etc. It is possible to employ a coating method in which shear strength is loaded in the plane direction parallel to the carrier film, or compression strength is loaded in the direction vertical to the carrier film plane.

In the present invention, a copper foil coated with a thermosetting resin containing electrically insulating whiskers is subjected to thermal compression molding to make a copper-clad laminate. As a result of such thermal press molding, the whiskers in the resin coated on the copper foil are let assume a state close to two-dimensional orientation, and at the same time the resin is cured to provide secure adhesion between the copper foil and the insulating layer. Thermal press molding can be accomplished using a hot press employed for thermal press molding of conventional copper-clad laminates, under the conditions used for forming the conventional copper-clad laminates: a pressure of 0.1-20 MPa, a temperature of 130-250°C and a period of 1-120 minutes.

In the manufacture of the copper-clad laminate according to the present invention, no intermediate article such as glass cloth which is subject to restrictions on thickness is used as base material as in the prior art but the very fine whiskers are used directly as base material in the production process, so that productivity is improved and also the thickness of the insulating layer can be optionally selected. Therefore, it is possible to make an ultra-thin copper-clad laminate which could never be produced with conventional glass cloth prepregs, and this greatly contributes to reduction of thickness of printed circuit boards.

In the conventional copper-clad laminates using glass cloth as base material, the crossing points of the yarns (filament strands) rise up to form an unevenness of about 5 µm on the surface of the laminate as the fibers are packed to a high density at the yarn intersections and hardly collapse during thermal press molding. In the copper-clad laminate of the present invention, however, such surface unevenness is less than 3 µm since the whiskers far smaller than the glass fibers are uniformly packed throughout the laminate. Because of excellent surface smoothness of the copper-clad laminate of this invention, the printed circuit boards made therefrom allow wiring of smaller size and higher density than possible with the conventional boards.

Since the whiskers used as base material of the insulating layer of the copper-clad laminate according to the present invention have better laser workability than glass cloth used as base material of the conventional copper-clad laminates, the insulating layer can be easily perforated by application of laser beams, which has been difficult with the conventional insulating layers using glass cloth. Consequently it has become possible to easily make the interstitial via holes (IVH) with small diameters of less than 100 µm, which enables fine and high-density wiring of circuits on the printed circuit boards and contributes greatly to the realization of higher performance of electronic devices.

It is also remarkable that the whiskers protrude to a moderate degree from the walls of the laser-formed holes in the insulating layer of the copper-clad laminate of this invention, so that plate adhesion of these holes is better than that of the holes formed by laser in the insulating layer made of a resin alone. This provides higher reliability of interlaminar connections of electric circuits, resulting in an enhanced reliability of the electronic devices.

Further, since the whiskers used as base material are uniformly dispersed in the insulating layer of the copper-clad laminate according to the present invention, there is little possibility of raising problems such as lost of core center and break of the drill that would be caused by maldistribution of glass cloth. This makes it possible to increase the ply number of the laminate to be drilled, resulting in providing improved productivity. Also, enhanced positional precision of the drilled holes enables finer and higher-density wiring on the circuit board, which greatly contributes to the performance elevation of electronic devices.

The base whiskers of the insulating layer of the copper-clad laminate according to the present invention have far higher rigidity than the conventional base glass and are more uniformly dispersed than in the conventional laminates. Therefore, the copper-clad laminate of the present invention has higher surface hardness and better wire bonding properties, thus allowing easier mounting of electronic parts, than the conventional copper-clad laminates using glass cloth.

Also, the copper-clad laminate of the present invention can be made higher in modulus of elasticity than the conventional copper-clad laminates using glass cloth by increasing the ratio of whiskers in the laminate, so that the printed circuit boards made by using this laminate can be increased in rigidity and lessened in deflection that would occur at the time of solder reflow or on other occasions, and their productivity can be enhanced by enlargement of work size and other merits of this laminate.

The copper-clad laminate of the present invention has far higher rigidity of the insulating layer than the glass cloth laminate and is uniformly strengthened by the whiskers with a low coefficient of thermal expansion and equal to or better than the conventional glass cloth laminates in dimensional stability, allowing finer and more compact arrangement of circuits on the printed circuit board. The printed circuit board made by using the copper-clad laminate of the present invention is small in coefficient of thermal expansion and also minimized in difference in coefficient of thermal expansion between the board and the electronic parts mounted thereon, so that the board is high in parts connecting reliability and can contribute to the enhancement of reliability of electronic devices.

Further, since the insulating layer of the copper-clad laminate according to the present invention is not composed of continuous fibers like glass cloth but is basically composed of fine and discontinuous whiskers, the probability of causing short-circuiting due to migration of copper ions which tend to move along fibers can be minimized, which adds to improvement of reliability of electronic devices.

On the other hand, the multilayer copper-clad laminate having interlayer circuits according to the present invention comprises an interlayer circuit plate and a copper foil for outer circuit interposing an electrically insulating layer therebetween and integrated by thermal press molding, said insulating layer containing electrically insulating whiskers uniformly dispersed in a thermosetting resin.

The process for producing the multilayer copper-clad laminate having interlayer circuits according to the present invention comprises the steps of uniformly dispersing electrically insulating whiskers in a thermosetting resin with stirring, coating the dispersion on the roughened side of a copper foil of which at least one side has been roughened, heating and drying the coating to remove the solvent while turning the resin into a half-cured state to form a prepreg having a copper foil, laminating the prepreg on the interlayer circuit plate having its circuit working completed so that the prepreg side (non-clad side) would face said circuit plate, and subjecting them to thermal press molding.

As the electrically insulating whiskers, there can be used those employed for the copper-clad laminate mentioned above.

The multilayer copper-clad laminate having interlayer circuits therein using the aluminum borate whiskers as base material in the outer insulating layer can give a multilayer printed circuit board having higher rigidity than obtainable with a circuit board using conventional glass cloth at room temperature and under high temperatures, as well as excellent connecting property by wire bonding, small coefficient of thermal expansion and excellent dimensional stability.

The average diameter of electrically insulating whiskers is preferably in the range from 0.1 to 3 µm. When the average diameter is less than 0.1 µm, mixing with the resin varnish becomes difficult and coating workability is deteriorated. On the other hand, when the average diameter is larger than 3 µm, surface smoothness is adversely affected and also microscopical uniform dispersibility of whiskers is impaired. For obtaining smoother coating, it is preferable to make the average diameter fall in the range from 0.5 to 2 µm.

As the thermosetting resin, there can be used those mentioned above as applicable to said copper-clad laminate.

The curing agent, curing accelerator and diluting solvent for the thermosetting resin may also be the same as employed for said copper-clad laminate.

If necessary, other commonly used additives such as coupling agent, filler, etc., may be properly mixed.

The amount of whiskers to be contained in the insulating layer is preferably 5 to 50% by volume as in the case of said copper-clad laminate for the same reasons as stated above.

For providing excellent hole filling properties in interlayer circuits and resin filling properties in circuits as well as equal or higher rigidity, dimensional stability and wire bonding properties of the produced multilayer printed circuit board compared with the printed circuit board using a conventional prepreg containing glass cloth, it is preferable that the content of whiskers in the outer insulating layer of the multilayer copper-clad laminate having interlayer circuits according to the present invention is 20 to 50% by volume based on the solid resin content.

As the copper foil, there can be used those mentioned above as employable for said copper-clad laminate. The thickness of the copper foil is preferably as small as possible, desirably less than 30 µm, for allowing formation of fine circuits. Use of an ultra-thin copper foil of less than 10 µm in thickness is more preferred, but in this case, since handling is difficult, it is recommended to use a copper foil with a carrier.

The resin varnish containing the whiskers can be applied to the copper foil by the same method as used for forming said copper-clad laminate mentioned above.

In the present invention, a copper foil coated with a thermosetting resin containing whiskers is thermally press molded with an interlayer circuit plate to make a multilayer copper-clad laminate having interlayer circuits therein. By this thermal press molding, the whiskers in the resin coated on the copper foil are brought into a state close to two-dimensional orientation while the resin is cured to provide secure adhesion between the copper foil and the insulating layer. Such thermal press molding can be accomplished by using a hot press commonly employed for thermal press molding of the conventional copper-clad laminates, under the normal thermal press molding conditions: a pressure of 1-20 MPa, a temperature of 130-250°C and a molding time of 1-120 minutes.

In the outer insulating layer of the multilayer copper-clad laminate having interlayer circuit according to the present invention, no intermediate article such as glass cloth which is subject to restrictions on thickness is used as base material in contrast to the prior art but the very fine whiskers are used directly as base material in the production process, so that productivity is high and the thickness of the insulating layer can be optionally selected. Therefore, it is possible to make a multilayer copper-clad laminate with interlayer circuit and having an ultra-thin outer insulating layer, which could never be produced with conventional glass cloth prepregs. This contributes greatly to reduction of thickness of the multilayer printed circuit boards.

In the conventional multilayer copper-clad laminates having interlayer circuits made by using the conventional glass cloth as base material, the glass fibers in the outer insulating layer are packed to a high density locally, such as at the intersections of the fibers, and these high-density fiber packed portions won't collapse during thermal press molding, so that there are generated texture roughened pattern or unevenness due to irregularity of interlayer circuit on the layer surface. However, in the multilayer copper-clad laminate having interlayer circuit according to the present invention, since a copper-clad prepreg having whiskers dispersed uniformly and in a relatively low concentration in a thermosetting resin is used in the production process, the whiskers collapse at a higher rate at the portion where interlayer circuit is present than the other portions to elevate the two-dimensional orientation degree and density, so that unevenness of interlayer circuit can be absorbed, and also since the whiskers used are far finer than the conventional glass fibers, the surface of the multilayer copper-clad laminate having interlayer circuit according to the present invention becomes very smooth. Thus, the multilayer copper-clad laminate of this invention has excellent surface smoothness, and the multilayer printed circuit board produced therefrom is capable of having fine and high-density wiring.

Further, since the whiskers used as base material in the outer insulating layer of the multilayer copper-clad laminate according to the present invention have far better laser workability than the conventional glass cloth, it is possible to easily perform laser drilling, which has been difficult with the conventional insulating layer using glass cloth. This makes it possible to easily form the interstitial via holes (IVH) of small diameters less than 100 µm, allowing fine and high-density wiring and doing much for miniaturization and enhancement of performance of electronic devices.

It is also notable that the whiskers protrude to a moderate degree from the walls of the holes formed by laser working in the outer insulating layer of the multilayer copper-clad laminate of this invention, so that plate adhesion of these holes is better than that of the holes formed by laser drilling in the insulating layer made of a resin alone. This increases reliability of wire bonding connections of electric circuits, resulting in an enhanced reliability of electric devices.

Further, since the whiskers used as base material are uniformly dispersed in the insulating layer of the multilayer copper-clad laminate according to the present invention, there is little risk of raising problems such as misalignment lost of core center or break of the drill that could be caused by maldistribution of glass. This makes it possible to increase the ply number of the laminate to be drilled, resulting in enhanced productivity. Also, elevated positional precision of the drilled holes enables finer and higher-density wiring on the circuit board, which contributes greatly to elevating performance of the electronic devices.

The base whiskers in the insulating layer of the multilayer copper-clad laminate according to the present invention have far higher rigidity than the conventional glass cloth and are more uniformly and thoroughly dispersed than in the conventional glass cloth laminates. Therefore, the multilayer copper-clad laminate of the present invention has higher surface hardness and better wire bonding properties, thus allowing easier mounting of electronic parts, than the conventional copper-clad laminates using glass cloth.

Also, the multilayer copper-clad laminate of the present invention can be made higher in modulus of elasticity than the conventional copper-clad laminates using glass cloth by increasing the content of whiskers in the laminate, so that the printed circuit boards made by using this laminate can be increased in rigidity and also lessened in deflection that could occur at the time of solder reflow or on other occasions, and their productivity can be enhanced by enlargement of work size and other merits of this laminate.

The multilayer copper-clad laminate of the present invention has far higher rigidity of the insulating layer than the glass cloth laminate and is uniformly strengthened by the whiskers with a low coefficient of thermal expansion and equal to or better than the conventional glass cloth laminates in dimensional stability, allowing finer and more compact arrangement of circuit on the printed circuit board. The printed circuit board made by using the multilayer copper-clad laminate of the present invention is small in coefficient of thermal expansion and also minimized in difference in coefficient of thermal expansion between the board and the electronic parts mounted thereon, so that the board is high in connecting reliability with the parts and can contribute to the enhancement of reliability of electronic devices.

Further, since the insulating layer of the multilayer copper-clad laminate according to the present invention is not composed of continuous fibers like glass cloth but is basically composed of fine and discontinuous whiskers, the probability of causing short-circuiting due to migration of copper ions which tend to move along the fibers can be minimized, which adds to improvement of reliability of electronic devices.

The present invention is further illustrated by the following Examples, in which all the parts and percents (%) are by weight unless otherwise noted.

### Example 1

In a thermosetting resin varnish comprising 100 parts of a bisphenol A novolak type epoxy resin, 47 parts of tetrabromobisphenol A, 37 parts of a bisphenol A novolak resin, 0.5 parts of 2-methyl-4-methylimidazole and 100 parts of methyl ethyl ketone, aluminum borate whiskers having an average diameter of 0.8 µm and an average fiber length of 20 µm were blended in a ratio of 11 parts to 100 parts of the resin solids and stirred until the aluminum borate whiskers were uniformly dispersed in the varnish. This dispersion was coated on a roughened side of an 18 µm thick one-side roughened electrolytic copper foil by a knife coater and dried by heating at 150°C for 10 minutes to remove the solvent while half-curing the resin. The knife coater gap was properly adjusted to make a prepreg with a copper foil in which the thickness of the prepreg layer composed of whiskers and half-cured resin was 60 µm. The whisker volume fraction of the prepreg layer was 35% by volume.

On this copper-clad prepreg was laminated an 18 µm thick one-side roughened copper foil so that its roughened side would face the prepreg side (non-clad side) of said prepreg, and they were subjected to thermal press molding under the conditions of 170°C and 2 MPa for a period of 6 minutes to obtain a copper-clad laminate of the present invention.

The copper foil of this copper-clad laminate was etched away and the bending modulus of elasticity of the laminate was measured by the three-point bending test. It was 20 GPa at normal (i.e. room) temperature and 10 GPa at 200°C. The coefficient of thermal expansion of the laminate as measured by TMA at normal temperature was 13 ppm/°C (average of lengthwise and breadthwise measurements, without copper foil). The surface hardness after removal of the copper foil was 60 (Vickers hardness).

Ten pieces of this copper-clad laminate were placed one over another and perforated by a 0.3 mm-diameter drill. The positional shift between the holes in the top and bottom laminates was less than 20 µm.

The surface roughness of this copper-clad laminate measured by a feeler (or contact finger) type surface roughness tester was about 2 µm.

Then the copper foil on one side of said copper-clad laminate was circularly etched away to form a 50 µm-diameter opening and CO₂ laser beams were applied to the insulating base material bared out from said opening. The oscillating frequency of the laser beams was 150 Hz, the irradiation pulse number was 5, and the energy fluence was 23.5 J/cm². The laminate was subjected to a smearing treatment with permanganic acid and then to electroless plating.

A sectional microscopical observation of the hole in this sample showed that the insulating layer at the lower portion of the hole was removed and said hole reached the copper foil on the other side. The hole wall tapered slightly in the direction where the hole diameter diminished gradually from the laser beam entering side toward the copper foil on the opposite side. The hole diameter at the copper foil portion on the opposite side was 40 µm, which was enough to secure an area of connection required for a conducting hole. A satisfactory plate throwing power on the hole wall was provided as the whiskers protruded by a length of around 3 µm from the resin portion.

After forming circuit on this copper-clad laminate, IC bare chips were mounted and connected to to the surface circuit by wire bonding. Good connection was obtained when wire bonding was conducted under the conditions of supersonic output of 1 W, supersonic output duration of 50 µs, bonding load of 100 g and bonding temperature of 180°C.

### Example 2

Two sheets of copper-clad prepreg having a prepreg layer thickness of 30 µm and the same resin composition as in Example 1 were laminated so that the prepreg sides of the respective sheets would face each other, and subjected to thermal press molding at 170°C under a pressure of 2 MPa for 60 minutes to obtain a copper-clad laminate with an insulating layer thickness of 60 µm.

The copper foil of this copper-clad laminate was etched away and its bending modulus of elasticity was measured by the three-point bending test. It was 20 GPa at normal temperature and 10 GPa at 200°C. The coefficient of thermal expansion of the laminate measured by TMA at normal temperature was 13 ppm/°C (average of lengthwise and breadwise measurements, with no copper foil). The surface hardness of the laminate after removal of the copper foil was 60 (Vickers hardness).

Ten pieces of this copper-clad laminate were placed one over another and perforated by a 0.3 mm-diameter drill. The positional shift between the holes in the top and bottom laminates was less than 20 µm.

The surface roughness of this copper-clad laminate measured by a feeler type surface roughness tester was about 2 µm.

The copper foil on one side of this copper-clad laminate was circularly etched away to form a 50 µm-diameter opening and the insulating base material bared out from this opening was exposed to CO₂ laser beams. The oscillating frequency of the laser beams was 150 Hz, the irradiation pulse number was 5, and the energy fluence was 23.5 J/cm². Then the laminate was subjected to a smearing treatment with permanganic acid and then to electroless plating.

Microscopic examination of the section of the hole in this sample laminate showed that the insulating layer at the lower portion of the hole exposed to laser beams has been removed and the hole reached the copper foil on the opposite side. The hole wall tapered slightly in the direction where the hole diameter diminished gradually from the laser beam entering side toward the copper foil on the opposite side. The hole diameter at the copper foil portion on the opposite side was 40 µm, which provided a sufficient area of connection required for a conducting hole. Also, plate throwing power on the hole wall was satisfactory since the whiskers protruded by a length of around 3 µm from the resin portion.

After forming circuit on this copper-clad laminate, IC bare chips were mounted thereon and connected to the surface circuit by wire bonding. Good connection was obtained by conducting wire bonding under the conditions of supersonic output of 1 W, supersonic output duration of 50 µs, bonding load of 100 g and bonding temperature of 180°C.

### Example 3

In the same thermosetting resin varnish as used in Example 1, aluminum borate whiskers having an average diameter of 0.8 µm and an average fiber length of 20 µm were blended in a ratio of 112 parts to 100 parts of resin solids, and the blend was stirred until the aluminum borate whiskers were uniformly dispersed in the varnish. This dispersion was coated on the roughened side of an 18 µm thick one-side roughened electrolytic copper foil by a knife coater and dried by heating at 150°C for 10 minutes to remove the solvent while half-curing the resin. The gap of the knife coater was properly adjusted to obtain a copper-clad prepreg in which the prepreg layer composed of said whiskers and half-cured resin was 10 µm. The whisker volume fraction of the prepreg layer was 35% by volume.

This copper-clad prepreg was hot press molded at 170°C under a pressure of 2 MPa for 60 minutes to obtain a single-sided copper-clad laminate with an insulating layer thickness of 10 µm.

The copper foil of this copper-clad laminate was etched away and the bending modulus of elasticity of the laminate was measured by the three-point bending method. It was 20 GPa at normal temperature and 10 GPa at 200°C. The coefficient of thermal expansion of the laminate measured by TMA at normal temperature was 10 ppm/°C (average of lengthwise and breadthwise measurements, with no copper foil).

Ten pieces of this copper-clad laminate were placed one over another and perforated by a 0.3 mm-diameter drill. The positional shift between the holes in the top and bottom laminates was less than 20 µm.

The surface roughness of this copper-clad laminate measured by a feeler type surface roughness tester was about 2 µm, indicating excellent surface smoothness of the laminate.

Some comparative examples are shown below to confirm the effect of the above embodiments of the present invention.

### Comparative Example 1

The same thermosetting resin varnish as used in Example 1 was impregnated in a 60 µm thick glass cloth and dried by heating at 150°C for 10 minutes to remove the solvent while half-curing the resin, thereby producing a 60 µm thick glass reinforced epoxy prepreg composed of said glass cloth and half-cured epoxy resin.

An 18 µm thick single-sided roughened copper foil was laminated on both sides of said prepreg so that the roughened side of each copper foil would face the prepreg surface, and hot press molded under the conditions of 170°C and 2 MPa for 60 minutes to obtain a conventional copper-clad laminate.

The bending modulus of elasticity of this laminate measured by the three-point bending method after removing the copper foil was 7 GPa at normal temperature and 4 GPa at 200°C. The coefficient of thermal expansion of this laminate measured by TMA at normal temperature was 15 ppm/°C (average of lengthwise and breadthwise measurements, with no copper foil attached).

The surface hardness of the laminate after removal of the copper foil was 17 (Vickers hardness). Ten pieces of this copper-clad laminate were placed one over another and perforated by a 0.3 mm-diameter drill. The positional shift between the holes in the top and bottom laminates was greater than 50 µm.

The surface roughness of this copper-clad laminate measured by a feeler type surface roughness tester was about 5 µm.

Then a predetermined position of the copper foil on one side of said copper-clad laminate was etched away to form a 50 µm-diameter circular hole and laser beams were applied to this hole. The oscillating frequency of the laser beams was 150 Hz, the irradiation pulse number was 5, and the energy fluence was 23.5 J/cm². Then this laminate was subjected to smearing treatment with permanganic acid and electroless plated. A sectional microscopical observation of the hole in this sample showed that although the resin of the insulating layer at the lower portion of the hole where laser beams were applied could be partly removed, the glass cloth remained unremoved. Naturally, the hole did not reach the copper foil on the other side, failing to form a through-hole.

After forming circuit on this copper-clad laminate, IC bare chips were mounted thereon and connected to the surface circuit by wire bonding. When wire bonding was conducted under the conditions of supersonic output of 1 W, supersonic output duration of 50 µs, bonding load of 100 g and bonding temperature of 180°C, there took place partial delamination of wires.

### Comparative Example 2

The same thermosetting resin as used in Example 1 was impregnated in a 30 µm thick glass cloth and dried by heating at 150°C for 10 minutes to remove the solvent while half-curing the resin to make a 30 µm thick glass-reinforced epoxy prepreg composed of said glass cloth and half-cured epoxy resin.

Two sheets of the thus produced prepreg were placed one on the other, and an 18 µm thick single-sided roughened copper foil was laminated on both sides thereof so that the roughened side of each copper foil would face the prepreg surface, and hot press molded at 170°C under a pressure of 2 MPa for 60 minutes to obtain a conventional copper-clad laminate with an insulating layer thickness of 60 µm.

After etching away the copper foil of the obtained copper-clad laminate, its bending modulus of elasticity was measured by a three-point bending test. It was 14 GPa at normal temperature and 7 GPa at 200°C. The coefficient of thermal expansion of the laminate measured by TMA at normal temperature was 20 ppm/°C (average of lengthwise and breadthwise measurements, with no copper foil attached).

The surface hardness of the laminate after removal of the copper foil was 17 (Vickers hardness). The positional shift between the holes in the top and bottom laminates of a stack of ten pieces of said copper-clad laminate perforated by a 0.3 mm-diameter drill was greater than 50 µm.

The surface roughness of this copper-clad laminate measured by a feeler type surface roughness tester was about 5 µm.

A predetermined position of the copper foil on one side of said copper-clad laminate was etched away to form a 50 µm-diameter circular hole and laser beams were applied to this hole under the following conditions: oscillating frequency = 150 Hz; irradiation pulse number = 5; energy fluence = 23.5 J/cm². Next, this sample was subjected to smearing treatment with permanganic acid and then electroless plated.

A sectional microscopical observation of the hole in the sample showed that although the resin of the insulating layer at the lower portion of the hole of the copper foil where laser beams were applied could be partly removed, the glass cloth remained unremoved. Naturally, the hole did not reach the copper foil on the other side, failing to form a through-hole.

After forming circuit on this copper-clad laminate, IC bare chips were mounted thereon and connected to the surface circuit by wire bonding. When wire bonding was conducted under the conditions of supersonic output of 1 W, supersonic output duration of 50 µs, bonding load of 100 g and bonding temperature of 180°C, there took place partial delamination of wires.

### Comparative Example 3

A thermosetting resin principally composed of a bisphenol A novolak type epoxy resin and a bisphenol A novolak resin was impregnated in a 10 µm thick glass cloth and dried by heating at 150°C for 10 minutes to remove the solvent while half-curing the resin, wishful of making a 10 µm thick glass-reinforced epoxy prepreg composed of glass cloth and said half-cured epoxy resin. However, the cloth could not put up with the weight of the coating resin and ruptured in the drying oven.

Thus, it was impossible to produce a copper-clad laminate with a 10 µm thick insulating layer, such as obtained in Example 3, by the conventional method of producing a copper-clad laminate using glass cloth as base material.

As described above, the copper-clad laminate produced according to the present invention has good circuit workability because of smooth surface, high packaging reliability because of high rigidity, good dimensional stability because of small coefficient of thermal expansion, and good wire bonding properties and drill workability because of high surface hardness.

Further, it is possible with the copper-clad laminate of the present invention to form holes by use of laser, which has been difficult with the conventional copper-clad laminates using glass cloth as base material. The plate throwing power on the inner walls of the holes is also satisfactory.

Moreover, in the copper-clad laminate according to the present invention, it is possible to reduce the insulating layer thickness to the order of 30 µm or less, which has been impossible with the conventional copper-clad laminates.

Therefore, the copper-clad laminate according to the present invention contributes greatly to the reduction of thickness, increase of wiring density, enhancement of productivity and elevation of reliability of the printed circuit boards.

### Example 4

In a thermosetting resin varnish composed of 100 parts of a bisphenol A novolak type epoxy resin, 47 parts of tetrabromobisphenol A, 37 parts of a bisphenol A novolak resin, 0.5 parts of 2-methyl-4-methylimidazole and 100 parts of methyl ethyl ketone, the aluminum borate whiskers having an average diameter of 0.8 µm and an average fiber length of 20 µm were blended in a ratio of 89 parts to 100 parts of the resin solids, and the blend was stirred until the aluminum borate whiskers were uniformly dispersed in the varnish. The dispersion was coated on a roughened side of an 18 µm thick single-sided roughened electrolytic copper foil by a knife coater and dried by heating at 150°C for 10 minutes to remove the solvent while half-curing the resin. The gap of the knife coater was adjusted to make a copper-foiled prepreg in which the thickness of the prepreg layer composed of said whiskers and half-cured resin was 30 µm. The whisker volume fraction of the prepreg layer was 30% by volume.

The thus obtained copper-clad prepreg was laminated on a double-sided copper-clad laminate with a copper foil thickness of 18 µm and an insulating layer thickness of 100 µm so that the prepreg side would face the circuit side of the interlayer circuit plate, and they were subjected to thermal press molding at 170°C under a pressure of 2 MPa for 60 minutes to make a multilayer copper-clad laminate having interlayer circuit formed therein. The surface roughness of this multilayer copper-clad laminate having interlayer circuit measured by a feeler type surface roughness tester was less than 2 µm, which indicates excellent surface smoothness of the laminate.

A predetermined position of the copper foil of said multilayer copper-clad laminate was etched to form a 50 µm-diameter circular hole, and laser beams were applied to this hole under the conditions of oscillating frequency = 150 Hz; irradiation pulse number = 5; energy fluence = 23.5 J/cm². This sample was subjected to smearing treatment with permanganic acid and then subjected to electroless copper plating. A sectional microscopical observation of the hole in the sample showed that the insulating layer in the laser beam applied area has been removed and the hole reached the interlayer circuit. The hole wall tapered slightly in the direction where the hole diameter diminished gradually from the laser beam entering side toward the interlayer circuit. The diameter at the bottom of the hole joined to the interlayer circuit was 40 µm, which secured a sufficient area of connection for a conducting hole. Since the whiskers protruded by a length of around 3 µm from the resin portion in the hole wall, the plate throwing power on the hole wall was high.

When five pieces of said multilayer copper-clad laminate were placed one over another and perforated by a 0.3 mm-diameter drill, the positional shift between the holes in the top and bottom laminates was less than 20 µm.

After forming circuit on said multilayer copper-clad laminate, IC bare chips were mounted thereon and connected to the surface circuit by means of wire bonding. Good connections was obtained by conducting wire bonding under the conditions of supersonic output of 1 W, supersonic output duration of 50 µs, bonding load of 100 g and bonding temperature of 180°C.

A part of this multilayer copper-clad laminate was cut out, and after etching away the outer copper foil, the external appearance of the cut-out portion of the laminate was observed. It had neither voids nor thin spots and showed good resin filling properties into the interlayer circuit. The bending modulus of elasticity of said multilayer copper-clad laminate measured by the three-point bending method after etching of the copper foil was 40 GPa at normal temperature and 20 GPa at 200°C. The coefficient of thermal expansion in the plane direction of the laminate measured by TMA at normal temperature after etching of the copper foil was 12 ppm/°C.

### Example 5

In a varnish composed of 100 parts of a salicylaldehyde novolak type epoxy resin, 70 parts of a bisphenol A novolak resin, 1 part of N-methylimidazole and 100 parts of methyl ethyl ketone, silicone nitride whiskers having an average diameter of 0.8 µm and an average fiber length of 20 µm were blended in a ratio of 89 parts to 100 parts of the resin solids, and the blend was stirred until the silicon nitride whiskers were uniformly dispersed in the varnish. The resulting dispersion was coated on a roughened side of an 18 µm thick single-sided roughened electrolytic copper foil by a knife coater and dried by heating at 150°C for 10 minutes to remove the solvent while half-curing the resin. The knife coater gap was properly adjusted to give a copper-foiled prepreg in which the thickness of the prepreg layer composed of said whiskers and half-cured resin was 30 µm. The whisker volume fraction of the prepreg layer was 30% by volume.

The thus obtained copper-foiled prepreg was laminated on a printed circuit board comprising a double-sided copper-clad laminate with a copper foil thickness of 18 µm and an insulating layer thickness of 100 µm having circuit formed thereon, said laminating being made such that the prepreg side would face the circuit side of the board, and the assemblage was hot press molded to provide a multilayer copper-clad laminate having interlayer circuits therein.

The surface roughness of this multilayer copper-clad laminate as measured by a feeler type surface roughness tester was less than 2 µm, indicating excellent surface smoothness of the laminate.

A predetermined position of the copper foil of said multilayer copper-clad laminate was etched to form a 50 µm-diameter circular hole and laser beams of an oscillating frequency of 150 Hz, an irradiation pulse number of 5 and an energy fluence of 23.5 J/cm² were applied to the hole. After smearing treatment with a permanganic acid, this sample laminate was subjected to electroless plating. A sectional microscopical observation of the hole of the sample laminate showed that the insulating layer of the area irradiated with laser beams has been removed and the hole reached the interlayer circuit. The hole wall tapered slightly in the direction where the hole diameter diminished gradually from the laser beam entering side toward the interlayer circuit. The diameter of the hole bottom portion joined to the interlayer circuit was 40 µm, sufficient to provide an area of connection required for a conducting hole. The plate throwing power on the hole wall was excellent due to around 3 µm protrusion of the whiskers from the resin portion.

The positional shift between the holes in the top and bottom laminates of a pile of 5 pieces of said multilayer copper-clad laminate perforated by a 0.3 mm-diameter drill was less than 20 µm.

After forming circuit on this multilayer copper-clad laminate, IC bare chips were mounted thereon and connected to the surface circuit by means of wire bonding. Good result was obtained when this wire bonding was conducted under the conditions of supersonic output of 1 W, supersonic output duration of 50 µs, bonding load of 100 g and bonding temperature of 180°C.

A part of said multilayer copper-clad laminate was cut out, and after etching away the copper foil, the external appearance was observed. There were no voids nor thin spots, and the laminate showed good resin filling properties into circuits. The bending modulus of elasticity of said laminate measured by the three-point bending method after etching away the copper foil was 40 GPa at normal temperature and 30 GPa at 200°C. The coefficient of thermal expansion in the plane direction of the laminate measured by TMA at normal temperature after etching removal of the copper foil was 13 ppm/°C.

Some comparative examples are shown below to confirm the effect of the above embodiments of the present invention.

### Comparative Example 4

The same resin varnish as used in Example 4 was impregnated in a 30 µm thick glass cloth and dried by heating at 150°C for 10 minutes to remove the solvent while half-curing the resin to make a 30 µm thick glass-reinforced epoxy prepreg composed of said glass cloth and half-cured epoxy resin.

This prepreg was laminated on both sides of a printed wiring board comprising a circuit-formed double-sided copper-clad laminate with a copper foil thickness of 18 µm and an insulating layer thickness of 100 µm, and further an 18 µm thick one-sided roughened electrolytic copper foil was laminated on the outside thereof so that the roughened side would face the prepreg, and the assemblage was hot press molded to produce a multilayer copper-clad laminate having interlayer circuits therein.

The surface roughness of this laminate measured by a feeler type surface roughness tester was greater than 8 µm.

A predetermined position of the external copper foil of said multilayer copper-clad laminate was etched to form a 50 µm-diameter circular hole and laser beams of an oscillating frequency of 150 Hz, an irradiation pulse number of 5 and an energy fluence of 23.5 J/cm² were applied to the hole. After smearing treatment with permanganic acid, this laminate was subjected to electroless copper plating. A sectional microscopic observation of the hole in this laminate showed that although the resin in the insulating layer of the laser beam applied area has been partly removed, the glass cloth remained unremoved. The hole didn't reach the interlayer circuit, hence no IVH could be formed.

The positional shift between the holes in the top and bottom laminates of a pile of 5 pieces of said laminate perforated by a 0.3 mm-diameter drill was greater than 50 µm.

After forming circuit on said multilayer copper-clad laminate, IC bare chips were mounted thereon and connected to the surface circuit by wire bonding. When wire bonding was carried out under the conditions of supersonic output of 1 W, supersonic output duration of 50 µs, bonding load of 100 g and bonding temperature of 180°C, there took place delamination of wires.

A part of said laminate was cut out and, after etching away its copper foil, its external appearance was visually observed. Thin spots were found on the laminate.

### Comparative Example 5

The same resin varnish as used in Example 4 was impregnated in a 20 µm thick glass cloth and dried by heating at 150°C for 10 minutes to remove the solvent while half-curing the resin with an intention to make a 30 µm thick glass-reinforced epoxy prepreg composed of said glass cloth and half-cured resin. It was intended to decrease the amount of glass while increasing the amount of resin to prevent generation of thin spots due to insufficient filling of resin into interlayer circuits observed in Comparative Example 1. However, the cloth could not endure the weight of the coating resin and ruptured in the drying oven.

### Comparative Example 6

A thermosetting resin having film-forming properties and principally composed of a high-molecular weight epoxy polymer with a weight average molecular weight of 500,000 and a bisphenol A epoxy resin was coated on a roughened side of an 18 µm thick single-side roughened electrolytic copper foil by a knife coater and dried by heating at 150°C for 10 minutes to remove the solvent while half-curing the resin. The knife coater gap was properly adjusted to give a copper-clad prepreg composed of a half-cured resin and a prepreg layer thickness of 30 µm.

This copper-clad prepreg was laminated on a printed circuit board for interlayer circuit, which had previously been made by forming circuit on a double-sided copper-clad laminate with a copper foil thickness of 18 µm and an insulating layer thickness of 100 µm, said laminate being made so that the prepreg surface would face the circuit side of the board, and the assemblage was hot press molded to make a multilayer copper-clad laminate having interlayer circuits therein.

The surface roughness of this multilayer copper-clad laminate measured by a feeler type surface roughness tester was less than 2 µm, indicating excellent surface smoothness of the laminate.

A predetermined position of the external copper foil of said multilayer copper-clad laminate was etched to form a 50 µm-diameter circular hole, and laser beams of an oscillating frequency of 150 Hz, an irradiation pulse number of 5 and an energy fluence of 23.5 FJ/cm² were applied to the hole. After smearing treatment with permanganic acid, this laminate was subjected to electroless copper plating. A sectional microscopic observation of the hole in the laminate showed that the insulating layer of the laser beam applied area has been removed and the hole reached the interlayer circuit. The hole wall tapered slightly in the direction where the hole diameter diminished gradually from the laser beam applied side toward the interlayer circuit. The diameter of the hole bottom portion joined to the interlayer circuit was 40 µm, which provided a sufficient area of connection for a conducting hole. The hole wall was smoother than Examples 1 and 2, and partial peel of plating was seen.

The positional shift between the holes in the top and bottom laminates of a pile of 5 pieces of the multilayer copper-clad laminate of this invention perforated by a 0.3 mm-diameter drill was less than 20 µm.

After forming circuit on said laminate, IC bare chips were mounted thereon and connected to the surface circuit by wire bonding. When wire bonding was conducted under the conditions of supersonic output of 1 W, supersonic output duration of 50 µs, bonding load of 100 g and bonding temperature of 180°C, there took place delamination of many wires.

A part of the laminate was cut out and, after etching away the external copper foil, the external appearance of the cut-out laminate was observed. There were no voids and no thin spots, and the laminate showed good resin filling properties into interlayer circuit. The bending modulus of elasticity of said laminate measured by the three-point bending method after etching away the copper foil was 20 GPa at normal temperature and 10 GPa at 200°C. The coefficient of thermal expansion of the laminate measured by TMA at normal temperature after etching away the copper foil was 20 ppm/°C.

As described above, the multilayer copper-clad laminate having interlayer circuits therein according to the present invention is capable of diminution of thickness and has excellent circuit workability because of good surface smoothness, high mounting reliability because of high rigidity, good wire bonding properties because of high surface hardness, and good dimensional stability because of low coefficient of thermal expansion. Therefore, the multilayer copper-clad laminate having interlayer circuits therein according to the present invention can greatly contribute to the diminution of thickness, increase of wiring density, enhancement of productivity, elevation of reliability and reduction of production cost of the multilayer printed circuit boards.

## Claims

1. A copper-clad laminate comprising an electrically insulating layer comprising a thermosetting resin and electrically insulating whiskers, and a copper foil formed on at least one side of the insulating layer, the insulating layer and copper foil being integrated by thermal press molding.

2. A copper-clad laminate according to claim 1, wherein the electrically insulating whiskers are ceramic whiskers having a modulus of elasticity of at least 200 GPa.

3. A copper-clad laminate according to claim 1 or 2, wherein the electrically insulating whiskers have an average diameter of 0.3-3 µm and an average length of at least 10 times the average diameter.

4. A copper-clad laminate according to any one of claims 1 to 3, wherein the electrically insulating whiskers are aluminum borate whiskers.

5. A process for producing a copper-clad laminate, which process comprises forming a blend by blending electrically insulating whiskers in a thermosetting resin, forming a dispersion by stirring the blend to disperse the whiskers uniformly in the resin, forming a coating by coating the dispersion on a roughened side of a copper foil of which at least one side has been roughened, heating and drying the coating to remove solvent to make a prepreg having a copper foil attached thereto, and:
(a) laminating a release film on the prepreg, subjecting them to thermal press molding and then separating the film;
(b) laminating two sheets of thus produced prepreg so that the prepreg sides of the respective sheets face each other, and subjecting them to thermal press molding; or
(c) laminating a copper foil of which at least one side has been roughened on the prepreg so that the roughened side of the copper foil and the prepreg side of the prepreg face each other, and subjecting them to thermal press molding.

6. A multilayer copper-clad laminate having an interlayer circuit therein, which laminate comprises an interlayer circuit plate, a copper foil for an outer circuit, and an electrically insulating layer interposed therebetween, the circuit plate, copper foil and insulating layer being integrated by thermal press molding, and the insulating layer comprising electrically insulating whiskers dispersed in a thermosetting resin.

7. A multilayer copper-clad laminate according to claim 6, wherein the electrically insulating whiskers are as defined in any one of claims 2 to 4.

8. A multilayer copper-clad laminate according to claim 6 or 7, wherein the thermosetting resin principally comprises an epoxy resin or a polyimide resin.

9. A process for producing a multilayer copper-clad laminate having an interlayer circuit therein, which process comprises forming a blend by blending electrically insulating whiskers in a thermosetting resin, forming a dispersion by stirring the blend to disperse the whiskers uniformly in the resin, forming a coating by coating the dispersion on the roughened side of a copper foil of which at least one side has been roughened, heating and drying the coating to remove solvent while turning the resin into a half-cured state to make a prepreg having a copper foil attached thereto, laminating the prepreg side of the prepreg on an interlayer circuit plate with its circuit working completed, and subjecting them to thermal press molding.
